# EUROPEAN PATENT APPLICATION

(11) **EP 4 641 218 A1**
(43) Date of publication of application: **29.10.2025**
(21) Application number: 23906779.6
(22) Date of filing: 08.12.2023
(51) Int. Cl.: G01R 15/18

(54) **ELECTRIC CURRENT SENSOR AND MEASUREMENT DEVICE**

(30) Priority: 19.12.2022 JP 2022202496; 23.10.2023 JP 2023181979
(71) Applicant: Hioki E.E. Corporation, Ueda-shi, Nagano 386-1192 (JP)
(72) Inventor: XIA, Peiyu, Ueda-shi, Nagano 386-1192 (JP); IKEDA, Kenta, Ueda-shi, Nagano 386-1192 (JP); NAKAZAWA, Koki, Ueda-shi, Nagano 386-1192 (JP); KARASAWA, Yuki, Ueda-shi, Nagano 386-1192 (JP)
(74) Representative: Reddie & Grose LLP
(86) International application number: PCT/JP2023/044051
(87) International publication number: WO 2024/135413

(57) **Abstract**

A current sensor includes an annular magnetic core, a pair of windings each including a plurality of winding sections connected in series and wound around different portions of the magnetic core, and a plurality of resistance elements. Each resistance element is connected in parallel to a respective winding section of the plurality of winding sections. The current sensor includes a return line with one end connected to one end of one winding of the pair of windings and the other end extending from the one end of the one winding to a position near the other end of the one winding along a portion of the magnetic core around which the one winding is wound, and a return line with one end connected to one end of the other winding of the pair of windings and the other end extending from the one end of the other winding to a position near the other end of the other winding along a portion of the magnetic core around which the other winding is wound. The current sensor outputs a signal indicating a difference between an output of the one winding and the return line and an output of the other winding and the return line.

## Description

### TECHNICAL FIELD

The present invention relates to a current sensor and a measurement device.

### BACKGROUND ART

US3146417A discloses a transformer in which a winding wound around a magnetic core includes a plurality of winding sections connected in series, and a damping resistor is connected in parallel to each winding section.

### SUMMARY OF INVENTION

In this transformer, since the winding including the plurality of winding sections connected in series forms a one-turn loop in a toroidal direction as a whole, external magnetic fluxes such as magnetic fields and electromagnetic waves entering from the outside are detected by the one-turn loop, and current detection accuracy deteriorates.

The present invention has been made in view of such a problem, and an object thereof is to improve current detection accuracy.

In an aspect of the present invention, a current sensor includes: an annular magnetic core; a pair of windings including a first winding and a second winding, the first winding and the second winding each including a plurality of winding sections connected in series and wound around different portions of the magnetic core in a poloidal direction along a toroidal direction to detect a current flowing through a measurement target; a plurality of resistance elements, each resistance element is connected in parallel to a respective winding section of the plurality of winding sections; a first return line with one end connected to one end of the first winding and the other end extending from the one end of the first winding to a position near the other end of the first winding along a toroidal direction of a portion of the magnetic core around which the first winding is wound; and a second return line with one end connected to one end of the second winding and the other end extending from the one end of the second winding to a position near the other end of the second winding along a toroidal direction of a portion of the magnetic core around which the second winding is wound, in which a signal indicating a difference between an output of the first winding and the first return line and an output of the second winding and the second return line is output.

In this aspect, the first winding and the second winding constituting the pair of windings are wound in the poloidal direction along the toroidal direction at the different portions of the magnetic core. Further, the first return line connected to the one end of the first winding extends along the toroidal direction of the portion around which the first winding is wound and extends from the one end of the first winding to the position near the other end of the first winding. Further, the second return line connected to the one end of the second winding extends along the toroidal direction of the portion around which the second winding is wound and extends from the one end of the second winding to the position near the other end of the second winding.

For this reason, when a difference between magnetism generated in the first winding and the first return line and magnetism generated in the second winding and the second return line is taken as the difference between the output of the first winding and the first return line and the output of the second winding and the second return line, at least a part of an external magnetic flux or the like detected by the first winding and the first return line can be canceled out by a magnetic flux generated in the second winding and the second return line, and as a result, current detection accuracy can be improved. Alternatively, when a difference between an electrical signal output through the first winding and the first return line and an electrical signal output through the second winding and the second return line is taken as the difference between the output of the first winding and the first return line and the output of the second winding and the second return line, at least a part of an in-phase component of noise caused by an external magnetic flux or the like of the electrical signal output through the first winding and the first return line can be canceled out by noise caused by an external magnetic flux or the like of the electrical signal output through the second winding and the second return line, and as a result, the current detection accuracy can be improved.

### BRIEF DESCRIPTION OF DRAWINGS

[FIG. 1] FIG. 1 illustrates a configuration of a measurement device including a current sensor according to a first embodiment.
[FIG. 2] FIG. 2 is a schematic diagram illustrating a configuration example of the current sensor according to the first embodiment.
[FIG. 3] FIG. 3 is a circuit diagram illustrating an equivalent circuit of the current sensor illustrated in FIG. 2.
[FIG. 4] FIG. 4 is a diagram for explaining an operation of the current sensor according to the first embodiment.
[FIG. 5] FIG. 5 illustrates flatness of amplitude-frequency characteristics of the current sensor according to the first embodiment.
[FIG. 6] FIG. 6 illustrates a configuration example of a current sensor according to a second embodiment.
[FIG. 7] FIG. 7 illustrates a configuration example of a current sensor according to a third embodiment.
[FIG. 8] FIG. 8 illustrates a configuration example of a current sensor according to a fourth embodiment.
[FIG. 9] FIG. 9 is a circuit diagram illustrating an equivalent circuit of the current sensor illustrated in FIG. 8.
[FIG. 10] FIG. 10 illustrates a configuration example of a current sensor according to a fifth embodiment.
[FIG. 11] FIG. 11 is a schematic diagram illustrating a configuration example of a current sensor according to a sixth embodiment.

### DESCRIPTION OF EMBODIMENTS

Hereinafter, embodiments of the present invention will be described with reference to the accompanying drawings. In this specification, the same or equivalent elements are denoted by the same reference numerals throughout the specification.

### (First Embodiment)

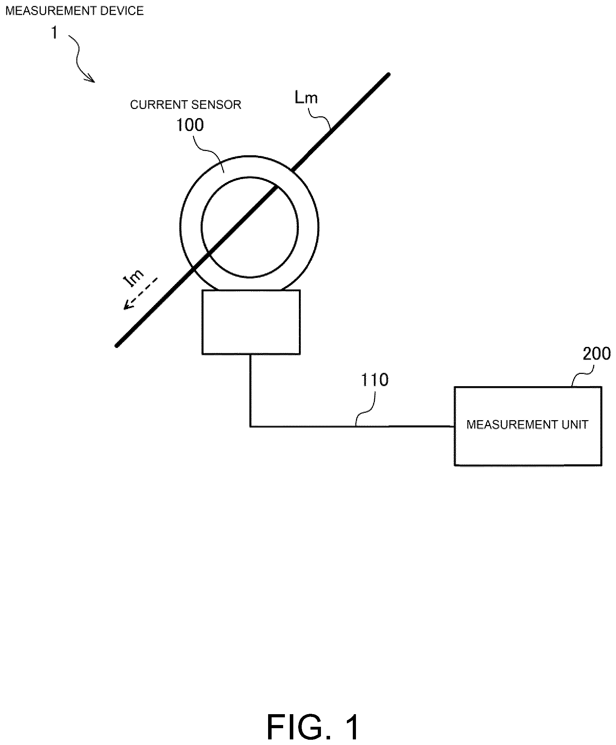

FIG. 1 illustrates a configuration of a measurement device 1 according to a first embodiment.

The measurement device 1 is a device for measuring a physical quantity of a measurement target Lm. The measurement target Lm is, for example, an electric circuit through which an alternating measurement current Im flows, and examples of the electric circuit include a single-phase or three-phase power cable. Examples of the physical quantity for the measurement target Lm include a current value, a magnetic flux value, and a power value.

The measurement device 1 measures a magnitude of the measurement current Im indicating a current flowing through the measurement target Lm. The measurement device 1 includes a current sensor 100 and a measurement unit 200.

The current sensor 100 is a sensor that detects a measurement magnetic flux indicating a magnetic flux generated by the alternating measurement current Im. The current sensor 100 outputs a voltage obtained by detecting the measurement magnetic flux to the measurement unit 200 as a detection quantity of the measurement current Im.

In the current sensor 100, a magnetic core around which at least one winding is wound is housed in a case. A structure of the current sensor 100 may be an inserted-type structure that allows the measurement target Lm to pass through, or may be an openable and closable clamp-type structure.

For example, the current sensor 100 is implemented by a winding detection-type current sensor that performs a current transformer (CT) operation to acquire a detection quantity of the measurement current Im. Alternatively, the current sensor 100 may be implemented by a current sensor that adopts a winding detection-type AC zero-flux method (magnetic balance method) and includes a magnetic detection element such as a fluxgate or a Hall element.

The current sensor 100 is provided with a cable 110. The cable 110 is implemented by, for example, a coaxial cable having a characteristic impedance of 50 [Ω] or 75 [Ω]. A tip of the cable 110 is connected to the measurement unit 200.

The measurement unit 200 calculates a measurement quantity for the measurement target Lm based on the detection quantity detected by the current sensor 100. The measurement unit 200 of the first embodiment calculates a current value of the measurement current Im flowing through the measurement target Lm based on the detection quantity indicating the magnitude of the voltage obtained by the current sensor 100. The measurement unit 200 is implemented by, for example, a power analyzer, a current measuring instrument, or a magnetic field measuring instrument.

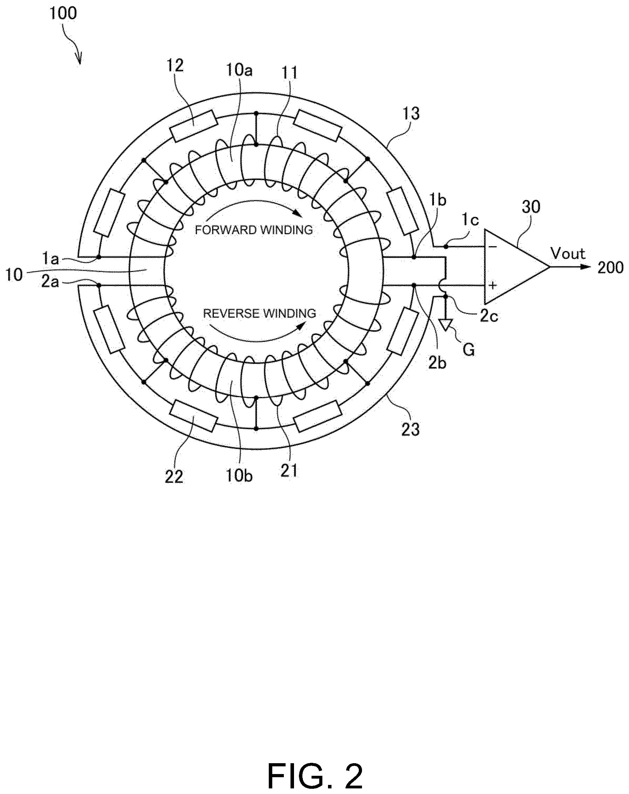

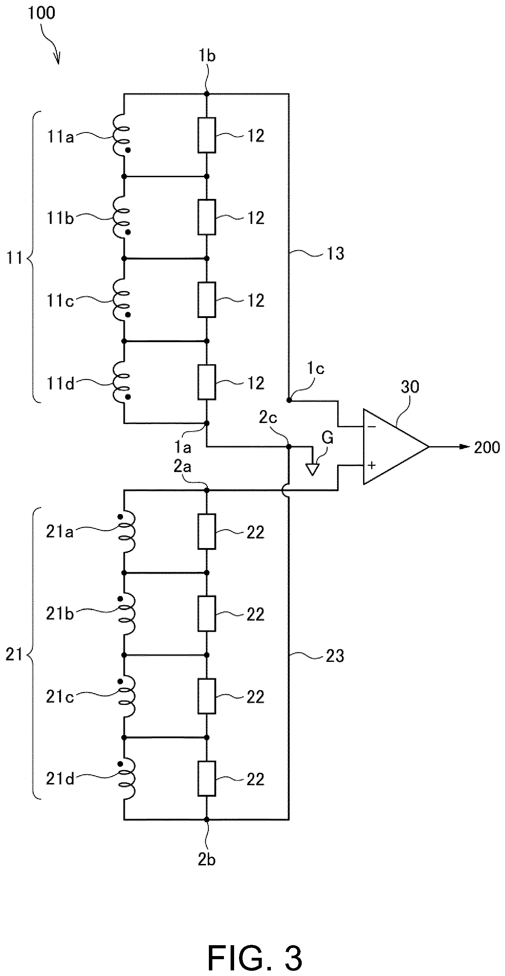

Next, a configuration of the current sensor 100 of the first embodiment will be described with reference to FIGS. 2 and 3.

FIG. 2 schematically illustrates a configuration of the current sensor 100.

The current sensor 100 includes a magnetic core 10, a winding 11, a plurality of resistance elements 12, a return line 13, a winding 21, a plurality of resistance elements 22, a return line 23, and a difference circuit 30. These components are housed in a case (not illustrated) as described with reference to FIG. 1.

The magnetic core 10 is formed such that the measurement target Lm can be inserted therethrough. Specifically, an overall shape of the magnetic core 10 is formed in an annular shape to surround the measurement target Lm. The annular shape here includes a circular shape, an elliptical shape, a rectangular shape, a polygonal shape, and the like. The magnetic core 10 is made of, for example, an iron material such as permalloy. Instead of the iron material, the magnetic core 10 may have a hollow structure. The magnetic core 10 may have a separable structure.

The winding 11 and the winding 21 are a pair of windings wound around different portions of the magnetic core 10 in the toroidal direction. In the first embodiment, the different portions includes a first magnetic core portion 10a and a second magnetic core portion 10b.

Specifically, the winding 11 is a first winding wound in a poloidal direction along the toroidal direction of the magnetic core 10. The winding 21 is a second winding wound in the poloidal direction along the toroidal direction of the magnetic core 10 in the second magnetic core portion 10b different from the first magnetic core portion 10a around which the winding 11 is wound in the magnetic core 10.

In the first embodiment, the pair of windings 11 and 21 are wound such that a direction from one end 1a of the winding 11 to the other end 1b of the winding 11 and a direction from one end 2a of the winding 21 to the other end 2b of the winding 21 are opposite to each other in the toroidal direction of the magnetic core 10. Specifically, the winding 11 is wound along the toroidal direction of the magnetic core 10 in the direction from the one end 1a to the other end 1b of the winding 11, and the winding 21 is wound along the toroidal direction of the magnetic core 10 in the direction opposite to the direction from the one end 1a to the other end 1b of the winding 11. The winding 21 is wound in a direction opposite to the direction in which the winding 11 is wound in the poloidal direction of the magnetic core 10. In this way, the winding 11 and the winding 21 are in a relationship of forward winding and reverse winding, respectively.

The pair of windings 11 and 21 are disposed to face each other such that the magnetic core 10 is bisected in a top view so as to improve line symmetry of the two in a radial direction of the magnetic core 10. In the first embodiment, the pair of semicircular windings 11 and 21 are disposed to face each other.

The one end 1a of the winding 11 is connected to the return line 13, and the other end 1b of the winding 11 is connected to a reference potential G. Similarly, the one end 2a of the winding 21 is connected to the return line 23, and the other end 2b of the winding 21 is connected to the reference potential G.

In the pair of windings 11 and 21, a plurality of winding sections are connected in series. Each of the resistance elements 12 is connected in parallel to a respective winding section of the plurality of winding sections in the winding 11. Similarly, each of the resistance elements 22 is connected in parallel to a respective winding section of the plurality of winding sections in the winding 21.

The return line 13 and the return line 23 are a pair of return lines that, for each winding of the pair of windings 11 and 21, return in opposite directions from one end to the other end of the winding along the toroidal direction of a portion of the magnetic core 10 around which the winding is wound.

Specifically, the return line 13 extends from the one end 1a of the winding 11 along the toroidal direction of the first magnetic core portion 10a of the magnetic core 10 around which the winding 11 is wound, and returns toward the other end 1b of the winding 11. Similarly, the return line 23 extends from the one end 2a of the winding 21 along the toroidal direction of the second magnetic core portion 10b of the magnetic core 10 around which the winding 21 is wound, and returns toward the other end 2b of the winding 21.

That is, the return line 13 constitutes a first return line with one end connected to the one end 1a of the winding 11 and the other end 1c extending from the one end 1a of the winding 11 to a position near the other end 1b of the winding 11 along the toroidal direction of the first magnetic core portion 10a of the magnetic core 10 around which the winding 11 is wound. Further, the return line 23 constitutes a second return line with one end connected to the one end 2a of the winding 21 and the other end 2c extending from the one end 2a of the winding 21 to a position near the other end 2b of the winding 21 along the toroidal direction of the second magnetic core portion 10b of the magnetic core 10 around which the winding 21 is wound.

The difference circuit 30 is a differential amplifier circuit that outputs a difference between an electrical signal output from the winding 11 and the return line 13 and an electrical signal output from the winding 21 and the return line 23.

In the first embodiment, the difference circuit 30 is implemented by the differential amplifier circuit. The other end 1c of the return line 13 is connected to an inverting input terminal (-) of the difference circuit 30, and the other end 2b of the winding 21 is connected to a non-inverting input terminal (+) of the difference circuit 30. The other end 2c of the return line 23 extending from the one end 2a of the winding 21 is connected to the reference potential G. The other end 1b of the winding 11 is also connected to the reference potential G.

The difference circuit 30 outputs and amplifies a difference between a voltage signal output from the winding 11 via the return line 13 and a voltage signal output from the return line 23 via the winding 21. Alternatively, the current sensor 100 may be configured such that the difference circuit 30 outputs and amplifies a difference between a voltage signal output from the return line 13 via the winding 11 and a voltage signal output from the winding 21 via the return line 23.

In this way, the difference circuit 30 outputs a signal indicating the difference between the voltage signal output through the winding 11 and the return line 13 and the voltage signal output through the winding 21 and the return line 23.

The difference circuit 30 generates an output signal indicating a magnitude of the difference between the voltage signal output through the winding 11 and the return line 13 and the voltage signal output through the winding 21 and the return line 23, and outputs the generated output signal to the measurement unit 200 as an output signal Vout of the current sensor 100.

Next, a connection relationship of the current sensor 100 will be described with reference to FIG. 3.

FIG. 3 is a circuit diagram illustrating an example of an equivalent circuit simulating electrical characteristics of the current sensor 100 according to the first embodiment. In FIG. 3, the winding 11 is divided into four sections, which are indicated as winding sections 11a to 11d, and the winding 21 is divided into four sections, which are indicated as winding sections 21a to 21d.

As illustrated in FIG. 3, the winding sections 11a to 11d are wound so as to be opposite in polarity to the winding sections 21a to 21d. An inductance of each of the winding sections 11a to 11d and the winding sections 21a to 21d is set to a value within a range of 1 [nF] to 10 [F], for example.

The resistance elements 12 are connected in parallel to the winding sections 11a to 11d while the resistance elements 12 are connected in series. The resistance elements 22 are connected in parallel to the winding sections 21a to 21d while the resistance elements 22 are connected in series.

Each of resistance values of the resistance elements 12 connected in series and the resistance elements 22 connected in series is set to a value within a range of 1 [Ω] to 100 [Ω], for example.

In the first embodiment, inductances of the winding sections 11a to 11d are set to be equal to each other so that detection sensitivities of the winding sections are equal to each other, and similarly, inductances of the winding sections 21a to 21d are set to be equal to each other.

Further, also for the resistance elements 12 and 22, the resistance values of the four resistance elements 12 are set to be equal to each other so that the detection sensitivities of the winding sections are equal to each other, and similarly, the resistance values of the four resistance elements 22 are set to be equal to each other.

In order to ensure the line symmetry of the pair of windings 11 and 21, the inductances of the winding sections 11a to 11d and the winding sections 21a to 21d are set to be equal, and the resistance values of the resistance elements 12 and the resistance elements 22 are also set to be equal.

In the first embodiment, the four resistance elements 12 are connected in parallel to the winding 11, but the present invention is not limited thereto. For example, two, three, or five or more resistance elements 12 may be connected in parallel to the winding 11. The same applies to the winding 21.

Next, an operation of the current sensor 100 will be described.

As illustrated in FIG. 2, in the current sensor 100, the pair of windings 11 and 21 are disposed to face each other such that the magnetic core 10 is bisected in the top view so as to improve the line symmetry of the two. In the first embodiment, the pair of semicircular windings 11 and 21 are disposed to face each other. Accordingly, the detection sensitivities of measurement magnetic fluxes by the winding 11 and the winding 21 become approximately the same.

In the current sensor 100, the pair of windings 11 and 21 each function as a current transformer. That is, the pair of windings 11 and 21 each convert a measurement magnetic flux generated in the magnetic core 10 by the measurement current Im illustrated in FIG. 1 into a current.

In the current sensor 100, the plurality of resistance elements 12 are impedance elements connected in series. The plurality of resistance elements 12 function as load resistors that convert induced currents flowing through the winding sections 11a to 11d of the winding 11, which are connected in parallel, into voltages. In addition, the plurality of resistance elements 12 function as damping resistors for suppressing deterioration of frequency characteristics caused by resonance between the inductance of the winding 11 and the capacitance parasitic on the winding 11. The same applies to the plurality of resistance elements 22.

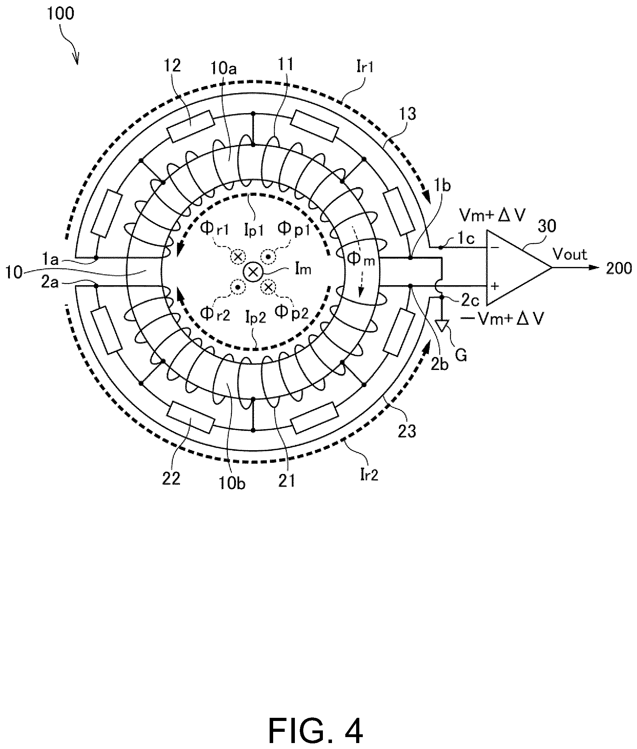

FIG. 4 is a diagram for explaining a current and a magnetic flux generated in the current sensor 100.

When a current flowing through the winding 11, which constitutes a part of the one-turn loop due to an external magnetic flux or the like, flows through the winding 21, which constitutes another part of the one-turn loop, a magnetic flux in a direction opposite to the external magnetic flux or the like is generated, and at least a part of an in-phase component of the external magnetic flux or the like is canceled out. Further, when a current flowing through the return line 13, which constitutes a part of the one-turn loop due to an external magnetic flux or the like, flows through the return line 23, which constitutes another part of the one-turn loop, a magnetic flux in a direction opposite to the external magnetic flux or the like is generated, and at least a part of an in-phase component of the external magnetic flux or the like is canceled out.

In a state in which the measurement target Lm is inserted into the magnetic core 10, a measurement magnetic flux φm is generated in the magnetic core 10 by the measurement current Im flowing through the measurement target Lm. The generation of the measurement magnetic flux φm causes an induced current proportional to the measurement magnetic flux φm to flow through each of the pair of windings 11 and 21.

Hereinafter, a magnetic flux generated mainly by a current component in the toroidal direction of the magnetic core 10 in the induced current flowing through the pair of windings 11 and 21 is referred to as a "parasitic magnetic flux". A magnetic flux generated by the current flowing through the pair of return lines 13 and 23 is also referred to as a "parasitic magnetic flux". These parasitic magnetic fluxes are generated in a central direction of the annular magnetic core 10, that is, in an insertion direction of the measurement target Lm. In this specification, the external magnetic flux or the like includes the parasitic magnetic flux.

A current component Ip1 in the toroidal direction of the magnetic core 10 in the induced current flowing through the winding 11 generates a parasitic magnetic flux φp1 in the insertion direction of the measurement target Lm. Similarly, a current component Ip2 in the toroidal direction flowing through the winding 21 generates a parasitic magnetic flux φp2 in the insertion direction of the measurement target Lm.

At this time, the current component Ip1 flowing through the winding 11 generates the parasitic magnetic flux φp1 caused by the winding 11 to cancel out the parasitic magnetic flux φp2 caused by the winding 21. Similarly, a current Ir1 flowing through the return line 13 of the winding 11 generates a parasitic magnetic flux φr1 caused by the return line 13 to cancel out a parasitic magnetic flux φr2 caused by the return line 23.

By disposing the pair of windings 11 and 21 in this way, the parasitic magnetic fluxes φp1 and φp2 caused by the pair of windings 11 and 21 act to cancel each other out. In addition, by disposing the pair of return lines 13 and 23, the parasitic magnetic fluxes φr1 and φr2 generated by the pair of return lines 13 and 23 act to cancel each other out.

Even with such a configuration, the parasitic magnetic fluxes φp1 and φp2 may not be canceled out due to a misalignment in the arrangement of the pair of windings 11 and 21, a misalignment in the arrangement of the pair of return lines 13 and 23, or a difference in the detection sensitivity of the external magnetic flux and the parasitic capacitance caused by a difference in the number of turns of the pair of windings 11 and 21.

Residual magnetic fluxes of the parasitic magnetic fluxes φp1 and φp2 that cannot be canceled out as described above are detected as common mode noise in the pair of windings 11 and 21.

Specifically, at both ends (1a and 1b) of the winding 11, a positive voltage +ΔV caused by the residual magnetic flux is superimposed as common mode noise on a positive voltage (+Vm) caused by the measurement magnetic flux φm. On the other hand, since the pair of windings 11 and 21 are wound such that the direction from the one end 1a of the winding 11 to the other end 1b of the winding 11 and the direction from the one end 2a of the winding 21 to the other end 2b of the winding 21 are opposite to each other in the toroidal direction of the magnetic core 10, a positive voltage +ΔV caused by the residual magnetic flux is superimposed as common mode noise on a negative voltage (-Vm) caused by the measurement magnetic flux φm at both ends (2a and 2b) of the winding 21.

In the difference circuit 30, by taking differences between the voltages (+Vm and +ΔV) generated in the winding 11 and the voltages (-Vm and +ΔV) generated in the winding 21, the voltages caused by the measurement magnetic flux φm are amplified, and the voltages +ΔV caused by the residual magnetic flux are canceled out.

For this reason, the difference circuit 30 outputs the output signal Vout from which the in-phase component of the noise caused by the residual magnetic fluxes of the parasitic magnetic fluxes φp1 and φp2 generated by the current components Ip1 and Ip2 in the toroidal direction of the pair of windings 11 and 21 is removed.

In addition, even if the number of turns of the pair of windings 11 and 21 is set to be the same, actually, a deviation (individual difference) occurs in detection sensitivity, parasitic capacitance, and the like between the winding 11 and the winding 21. The in-phase component of the noise directly caused by the deviation in the detection sensitivity and the parasitic capacitance between the windings 11 and 21 themselves can be similarly removed by the difference circuit 30. For this reason, the difference circuit 30 outputs the output signal Vout from which not only the in-phase component of the noise caused by the residual magnetic flux described above but also the in-phase component of the noise directly caused by the individual difference in the detection sensitivity and the parasitic capacitance between the windings themselves are removed.

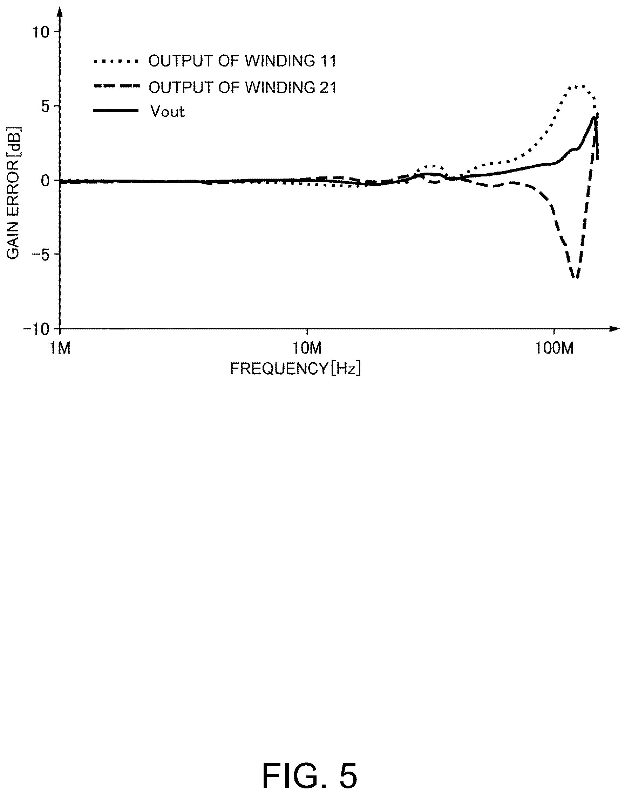

Next, an output error of the current sensor 100 will be described with reference to FIG. 5.

FIG. 5 illustrates frequency characteristics with respect to output errors measured actually, in which a vertical axis represents an amplitude gain error and a horizontal axis represents a frequency.

In the example illustrated in FIG. 5, the frequency characteristic of the gain error for the output signal Vout of the current sensor 100 is indicated by a solid line, the frequency characteristic of the gain error for an output of the winding 11 is indicated by a dotted line, and the frequency characteristic of the gain error for an output of the winding 21 is indicated by a dashed line.

As illustrated in FIG. 5, in a frequency band higher than 40 [MHz], the gain error in the output of the winding 11 increases on a positive side, whereas the gain error in the output of the winding 21 increases on a negative side. The reason why the gain error increases is due to an external magnetic flux such as a magnetic field or an electromagnetic wave entering from the outside and the residual parasitic magnetic flux described above.

In addition, since the pair of windings 11 and 21 are wound in opposite directions and the directions in which the gain error increases are also opposite, it can be seen that the common mode noise is dominant in the noise.

Therefore, in the first embodiment, the common mode noise is reduced by adopting the differential amplifier circuit as the difference circuit 30. Therefore, the current sensor 100 can suppress the influence of the external magnetic flux or the like that cannot be canceled out by the pair of return lines 13 and 23 on the output signal Vout.

FIG. 5 illustrates the frequency characteristic of the gain error as an example of the output error of the current sensor 100. For the frequency characteristic of the phase error in the current sensor 100, an increase in the phase error is also suppressed in a high frequency band.

Next, functions and effects of the first embodiment will be described.

In the first embodiment, the current sensor 100 includes the annular magnetic core 10, the pair of windings 11 and 21 including the plurality of winding sections 11a to 11d and 21a to 21d connected in series and the plurality of resistance elements 12 and 22. Each resistance element 12 is connected in parallel to a respective winding section among the plurality of winding sections 11a to 11d, and each resistance element 22 is connected in parallel to a respective winding section among the plurality of winding sections 21a to 21d. The pair of windings 11 and 21 are wound around different portions of the magnetic core 10 in the poloidal direction along the toroidal direction to output the current flowing through the measurement target Lm. Of the pair of windings 11 and 21, the winding 11 constitutes the first winding, and the winding 21 constitutes the second winding.

Further, the current sensor 100 includes, for each winding, the pair of return lines 13 and 23 that return from one end to the other end of the winding along the toroidal direction of the portion of the magnetic core 10 around which the winding is wound. Specifically, the return line 13 constitutes the first return line with one end connected to the one end 1a of the winding 11 as the first winding and the other end 1c extending from the one end 1a of the winding 11 to the position near the other end 1b of the winding 11 along the toroidal direction of the first magnetic core portion 10a of the magnetic core 10 around which the winding 11 is wound. Further, the return line 23 constitutes the second return line with one end connected to the one end 2a of the winding 21 as the second winding and the other end 2c extending from the one end 2a of the winding 21 to the position near the other end 2b of the winding 21 along the toroidal direction of the second magnetic core portion 10b of the magnetic core 10 around which the winding 21 is wound.

The current sensor 100 outputs a signal indicating a difference between an output of the winding 11 and the return line 13 as the first winding and the first return line and an output of the winding 21 and the return line 23 as the second winding and the second return line.

With this configuration, as illustrated in FIG. 2, in the current sensor 100 of the first embodiment, since the pair of windings 11 and 21 are respectively wound around the first magnetic core portion 10a and the second magnetic core portion 10b of the magnetic core 10, which are different from each other, an increase in parasitic capacitance of each of the windings 11 and 21 is suppressed. Accordingly, in the frequency characteristics of the amplitude and the phase of each of the windings 11 and 21, deterioration of flatness due to an increase in parasitic capacitance is suppressed.

Further, in the current sensor 100, the plurality of resistance elements 12 and 22 are connected in parallel to the respective winding sections of the pair of windings 11 and 21, and thus a plurality of circuits constituted by the winding sections and parasitic capacitances thereof are formed in series.

The inductance and the capacitance of the parasitic capacitance of the winding section in each of the circuits are both smaller than the inductance and the capacitance of the parasitic capacitance of each of the entire windings 11 and 21. For this reason, a resonance frequency determined by the pair of windings 11 and 21 and the parasitic capacitances thereof is sufficiently higher than a resonance frequency of a winding having no resistance elements connected in series. Therefore, the flatness of the frequency characteristics with respect to the amplitude and the phase of the current sensor 100 is improved in the high frequency band.

Further, the inductances of the winding sections 11a to 11d and the winding sections 21a to 21d are set to be equal, and the resistance values of the resistance elements 12 and the resistance elements 22 are set to be equal. By adopting such a line-symmetric structure, a decrease in measurement accuracy due to the misalignment in a conductor position of the measurement target Lm inserted into the annular magnetic core 10 is suppressed.

In addition, the current sensor 100 outputs a signal indicating a difference between magnetism from the winding 11 and the return line 13 and magnetism from the winding 21 and the return line 23. In the first embodiment, the output signal Vout of the current sensor 100 includes the signal indicating the difference between the magnetism generated in the winding 11 and the return line 13 and the magnetism generated in the winding 21 and the return line 23.

Specifically, in the current sensor 100, the pair of windings 11 and 21 are wound such that the direction from one end of the winding 11 to the other end of the winding 11 and the direction from one end of the winding 21 to the other end of the winding 21 are opposite to each other in the toroidal direction of the magnetic core 10, and the pair of windings 11 and 12 are wound in opposite directions in the poloidal direction of the magnetic core 10.

At the same time, the other end 1b of the return line 13 is extended to the position near the other end 1b of the winding 11 while the return line 13 whose one end 1a is connected to the one end 1a of the winding 11 is arranged along a circumference (toroidal direction) of the magnetic core 10. The other end 2c of the return line 23 is extended to the position near the other end 2b of the winding 21 while the return line 23 whose one end is connected to the one end 2a of the winding 21 is arranged along the circumference (toroidal direction) of the magnetic core 10 in a direction opposite to the return line 13. The other end 2c of the return line 23 is connected to the other end 1b of the winding 11.

With this configuration, when the current flowing through the winding 11, which constitutes a part of the one-turn loop due to the external magnetic flux or the like, flows through the winding 21, which constitutes another part (remaining part) of the one-turn loop, the magnetic flux in the direction opposite to the external magnetic flux or the like is generated, and at least a part of the in-phase component of the external magnetic flux or the like is canceled out. Further, when the current flowing through the return line 13, which constitutes a part of the one-turn loop due to the external magnetic flux or the like, flows through the return line 23, which constitutes another part of the one-turn loop, the magnetic flux in the direction opposite to the external magnetic flux or the like is generated, and at least a part of the in-phase component of the external magnetic flux or the like is canceled out.

For this reason, when detecting the measurement current Im, the current sensor 100 can reduce noise caused by the external magnetic flux or the like, and as a result, the current detection accuracy can be improved.

In the current sensor 100, the pair of return lines 13 and 23 extend in opposite directions along the toroidal direction of the magnetic core 10. That is, the pair of return lines 13 and 23 are wired such that the one ends 1a and 2a of the pair of return lines 13 and 23 are adjacent to each other.

With this configuration, since the other ends 1c and 2c of the pair of return lines 13 and 23 tend to approach each other, the wiring of the pair of return lines 13 and 23 to the difference circuit 30 is shortened, and the routing of the wiring is easily designed.

In the current sensor 100, the number of turns of the winding 11 is equal to the number of turns of the winding 21.

With this configuration, since the external magnetic fluxes or the like detected by the winding 11 and the winding 21 are equal to each other, the noise caused by the external magnetic flux or the like can be further reduced.

In addition, in the current sensor 100, a circumferential length of the portion of the magnetic core 10 around which the winding 11 is wound is equal to a circumferential length of the portion of the magnetic core 10 around which the winding 21 is wound.

With this configuration, since a length of the return line 13 and a length of the return line 23 are equal, the external magnetic fluxes or the like detected by the return line 13 and the return line 23 are equal, and thus it is possible to further reduce the noise caused by the external magnetic flux and the like.

In the current sensor 100, the pair of windings 11 and 21 are disposed in the magnetic core 10 such that the one ends 1a and 2a of the pair of windings 11 and 21, which are the one ends 1a and 2a of the pair of return lines 13 and 23, are adjacent to each other.

With this configuration, since the other ends 1b and 2b of the pair of windings 11 and 21 are adjacent to each other, a distance between the other ends 1c and 2c of the pair of return lines 13 and 23 extending toward the other ends 1b and 2b of the pair of windings is also shortened.

Accordingly, it is possible to shorten the distance for routing the pair of return lines 13 and 23 to a pair of input terminals of the difference circuit 30. For this reason, it is possible to suppress noise from being mixed into the routed lines as the pair of return lines 13 and 23 are routed.

In addition, the current sensor 100 includes the difference circuit 30 that outputs an output signal Vout including a difference between electrical signals output from the pair of windings 11 and 21 through the pair of return lines 13 and 23, respectively.

That is, the current sensor 100 includes the difference circuit 30 that outputs a signal indicating a difference between electrical signals from both the winding 11 and the return line 13 and the winding 21 and the return line 23, and an output of the difference circuit 30 indicates a difference between outputs from both. In this way, the current sensor 100 outputs the signal indicating the difference between the electrical signal from the winding 11 and the return line 13 and the electrical signal from the winding 21 and the return line 23.

Specifically, in the current sensor 100, the pair of windings 11 and 21 are wound in opposite directions in the toroidal direction of the magnetic core 10. The other end 1c of the return line 13 extending from the one end 1a of the winding 11 included in the pair of windings is connected to the inverting input terminal (-) as a first input terminal of the difference circuit 30, and the other end 2b of the winding 21 is connected to the non-inverting input terminal (+) as a second input terminal of the difference circuit 30. The other end 2c of the return line 23 extending from the one end 2a of the winding 21 and the other end 1b of the winding 11 are connected to the reference potential G.

With this configuration, the pair of return lines 13 and 23 can cancel out the external magnetic flux or the like, and the difference circuit 30 can remove the in-phase component of the noise caused by the external magnetic flux or the like that cannot be canceled out. Specifically, due to the differential amplification in the difference circuit 30, a level of a signal proportional to the measurement current Im among the output signals of the pair of windings 11 and 21 increases, and a level of a noise voltage decreases. As a result, the current detection accuracy of the current sensor 100 can be improved.

In this way, in the current sensor 100, in order to obtain the difference between the magnetism generated in the winding 11 and the return line 13 as the first winding and the first return line and the magnetism generated in the winding 21 and the return line 23 as the second winding and the second return line, the outputs of both the winding 11 and the return line 13 and the winding 21 and the return line 23 are input to the difference circuit 30. The difference circuit 30 generates the output signal Vout including the difference between the electrical signals from the two in addition to the difference between the magnetism generated in the two.

Therefore, the output signal Vout of the current sensor 100 includes the difference between the magnetism generated in a pair of components including the return lines 13 and 23 disposed to cancel out the external magnetic flux or the like, and the difference between the electrical signals output from the pair of components obtained by the difference circuit 30 for removing the in-phase component of the noise caused by the external magnetic flux or the like that cannot be canceled by the pair of return lines 13 and 23. That is, the difference between the output of the first winding and the first return line and the output of the second winding and the second return line includes the difference in magnetism and the difference in electrical signals.

For this reason, with the above configuration, the external magnetic fluxes or the like generated by the pair of windings 11 and 21 can be canceled out by the pair of return lines 13 and 23, and the in-phase component of the noise caused by the external magnetic flux or the like that cannot be canceled out can be suppressed by the difference circuit 30. Therefore, the current detection accuracy of the current sensor 100 can be improved.

In the current sensor 100, the resistance values of the plurality of resistance elements 12 and 22 are equal to each other.

With this configuration, the winding sections connected in parallel to the resistance elements 12 and the winding sections connected in parallel to the resistance elements 22 have the same detection sensitivity. For this reason, it is possible to suppress the fluctuation of the detection accuracy due to the positional relationship of the measurement target Lm inserted into the magnetic core 10.

Therefore, it is possible to suppress a decrease in detection accuracy due to a positional deviation of the measurement target Lm with respect to the magnetic core 10 while increasing an upper limit of a detectable frequency band.

The measurement device 1 of the first embodiment includes the current sensor 100 and the measurement unit 200 that calculates the measurement quantity of the measurement target Lm based on the detection quantity detected by the current sensor.

With this configuration, since the measurement quantity of the measurement target Lm is calculated based on the output signal of the current sensor 100, the upper limit of the measurable frequency band can be increased as compared with a general measurement device including a current sensor that does not include the pair of return lines 13 and 23 and the difference circuit 30. Therefore, the measurement target Lm can be accurately measured in a higher frequency band.

### (Second Embodiment)

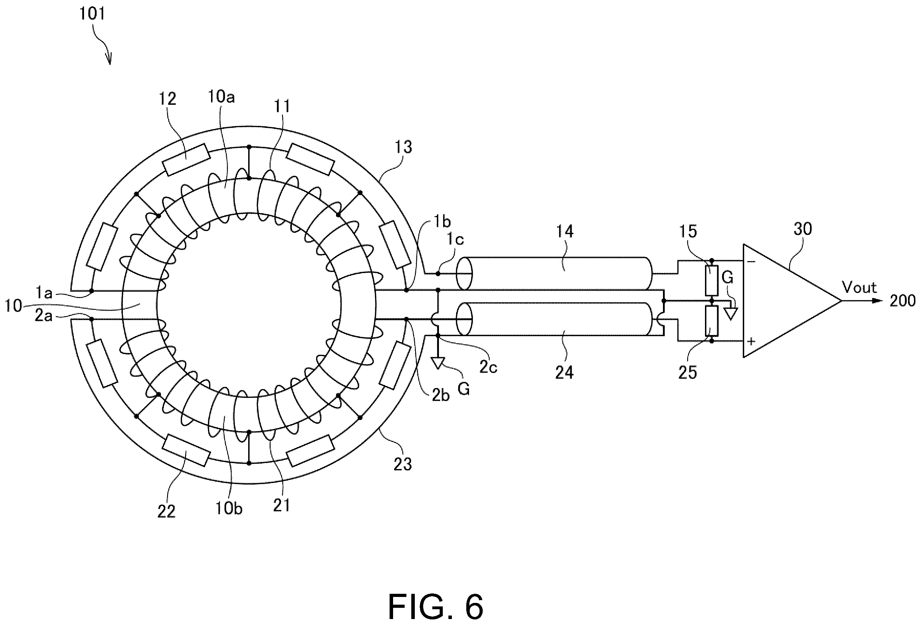

FIG. 6 illustrates a configuration of a current sensor 101 according to a second embodiment. In the second embodiment, it is assumed that there is a large distance between the difference circuit 30 and other components such as the pair of windings 11 and 21.

The current sensor 101 includes a pair of transmission lines 14 and 24 and a pair of resistance elements 15 and 25 in addition to the configuration of the current sensor 100 of the first embodiment. Here, in the current sensor 101 of the second embodiment, the same or equivalent components as those of the current sensor 100 illustrated in FIG. 2 are denoted by the same reference numerals as those assigned to the components of the current sensor 100, and redundant descriptions thereof will be omitted.

The pair of transmission lines 14 and 24 are transmission lines for transmitting output signals of the pair of windings 11 and 21 to the difference circuit 30. The pair of transmission lines 14 and 24 are, for example, coaxial transmission lines, and as a specific example, are implemented by a coaxial cable having a characteristic impedance of 50 [Ω] or 75 [Ω].

Each of the transmission lines 14 and 24 includes an inner conductor, an outer conductor, and an insulator disposed therebetween.

In the transmission line 14, an input end of the inner conductor is connected to the other end 1c of the return line 13, and an input end of the outer conductor is connected to the reference potential G and the other end 1b of the winding 11. In the transmission line 24, an input end of the inner conductor is connected to the other end 2b of the winding 21, and an input end of the outer conductor is connected to the reference potential G and the other end 2c of the return line 23.

The pair of resistance elements 15 and 25 have a function of implementing impedance matching by a termination resistor corresponding to the characteristic impedance of the pair of transmission lines 14 and 24. The pair of resistance elements 15 and 25 connect resistance elements of, for example, 50 [Ω] or 75 [Ω].

One end of the resistance element 15 is connected to an output end of the inner conductor of the transmission line 14 and the inverting input terminal (-) of the difference circuit 30. The other end of the resistance element 15 is connected to the reference potential G and the output end of the outer conductor of the transmission line 14.

One end of the resistance element 25 is connected to the output end of the inner conductor of the transmission line 24 and the non-inverting input terminal (+) of the difference circuit 30. The other end of the resistance element 25 is connected to the reference potential G and the output end of the outer conductor of the transmission line 24.

In such a configuration, a sum of the resistance values of the four resistance elements 12 connected in parallel to the winding 11 is set to be equal to the characteristic impedance of the transmission line 14. Similarly, a sum of the resistance values of the four resistance elements 22 connected in parallel to the winding 21 is set to be equal to the characteristic impedance of the transmission line 14.

Next, functions and effects of the second embodiment will be described.

The current sensor 101 of the second embodiment has the same configuration as the current sensor 100 of the first embodiment, and can achieve the same functions and effects as the first embodiment.

In addition, the current sensor 101 includes the transmission lines 14 and 24 for transmitting output signals of the windings 11 and 21 to the difference circuit 30 as a pair of transmission lines for transmitting an output of the winding 11 and the return line 13 and an output of the winding 21 and the return line 23 to the difference circuit 30. A sum of the resistance values of the resistance elements 12 or 22 connected in series, which are connected in parallel to at least one of the windings 11 or 21, is approximately equivalent to the characteristic impedance of the transmission line 14 or 24 corresponding to at least one of the windings 11 or 21.

With this configuration, since the characteristic impedance of the transmission line 14 or 24 is equal to the sum of the resistance values of the resistance elements 12 or 22 connected in series, the output signal of the winding 11 or 21 can be suppressed from being reflected at one end of the transmission line 14 or 24. Accordingly, it is possible to reduce a detection error caused by reflection in the transmission line 14 or 24.

In the second embodiment, the example in which the difference circuit 30 is disposed in the current sensor 101 has been described, but the difference circuit 30 may be disposed in the measurement unit 200 illustrated in FIG. 1. In this case, the cable 110 illustrated in FIG. 1 includes the pair of transmission lines 14 and 24 illustrated in FIG. 6.

### (Third Embodiment)

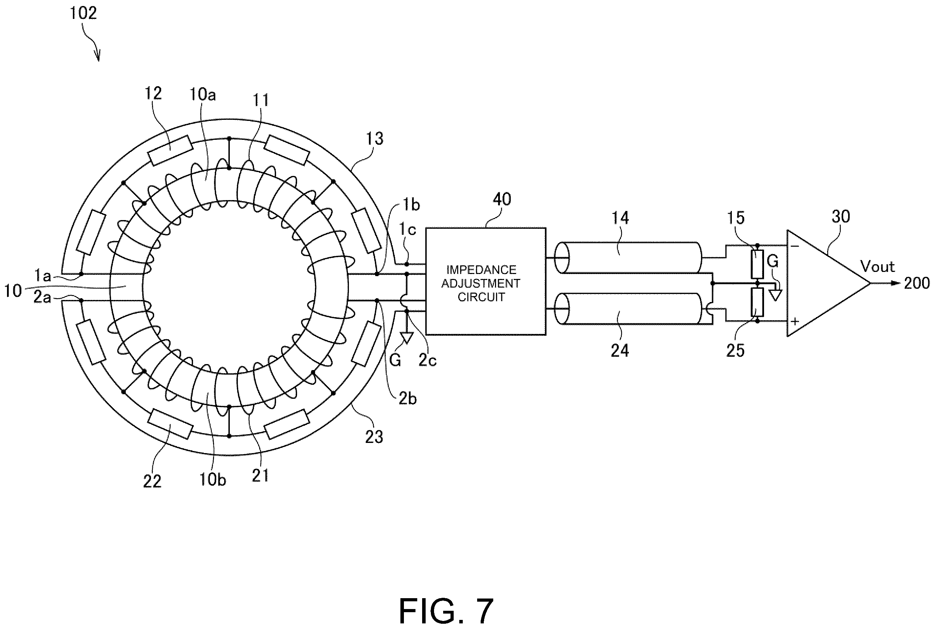

FIG. 7 illustrates a configuration of a current sensor 102 according to a third embodiment.

The current sensor 102 of the third embodiment includes an impedance adjustment circuit 40 in addition to the configuration of the current sensor 101 of the second embodiment. Here, in the current sensor 102 of the third embodiment, the same components as those of the current sensor 101 illustrated in FIG. 6 are denoted by the same reference numerals, and redundant descriptions thereof will be omitted.

The impedance adjustment circuit 40 adjusts an impedance viewed from the input end of the transmission line 14 to the characteristic impedance of the transmission line 14. Further, the impedance adjustment circuit 40 adjusts an impedance viewed from the input end of the transmission line 24 to the characteristic impedance of the transmission line 24. In this way, the impedance adjustment circuit 40 adjusts the impedance viewed from at least one input end of the pair of transmission lines 14 and 24 to the characteristic impedance of at least one transmission line.

Next, functions and effects of the third embodiment will be described.

The current sensor 102 of the third embodiment has the same configuration as the current sensor 101 of the second embodiment, and can achieve the same functions and effects as the second embodiment.

In addition, in the third embodiment, the current sensor 102 includes the impedance adjustment circuit 40 that adjusts the impedance viewed from the input end of the transmission line 14 or 24 to the characteristic impedance of the transmission line 14 or 24. The transmission line 14 or 24 constitutes a pair of transmission lines for transmitting the output of the winding 11 and the return line 13 and the output of the winding 21 and the return line 23 to the difference circuit 30.

With this configuration, the current sensor 102 can adjust the impedance viewed from the input end of the transmission line 14 or 24 and the characteristic impedance of the transmission line 14 or 24 to be equal in the impedance adjustment circuit 40.

For this reason, even when the sum of the resistance values of the resistance elements 12 or 22 connected in series, which are connected in parallel to the winding 11 or 21, is not made equal to the characteristic impedance of the transmission line 14 or 24, it is possible to suppress the output signal of the winding 11 or 21 from being reflected at one end of the transmission line 14 or 24. Accordingly, it is possible to reduce a detection error caused by reflection in the transmission line 14 or 24.

### (Fourth Embodiment)

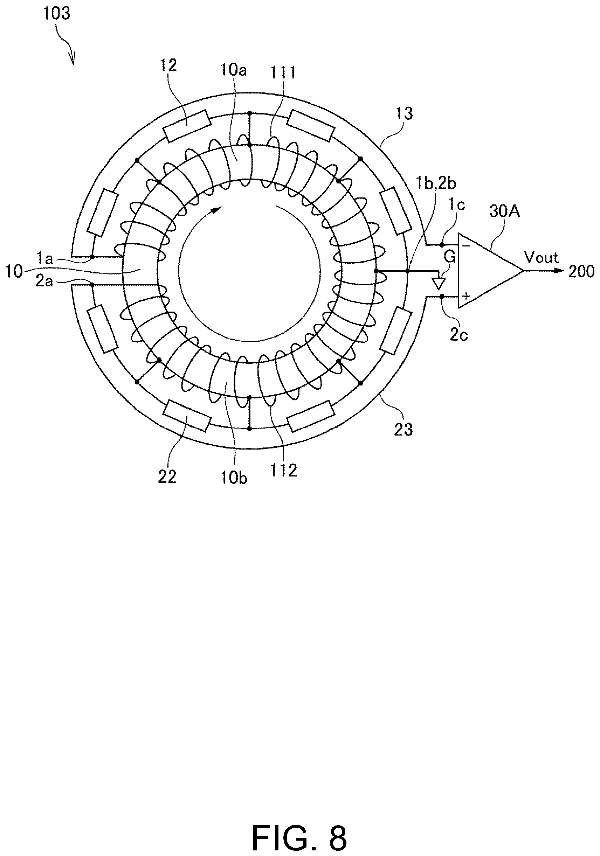

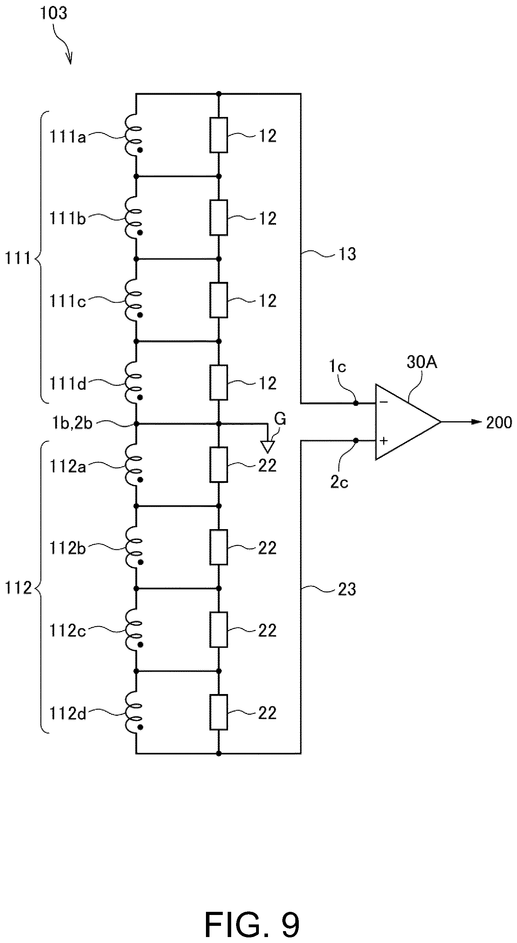

Next, a current sensor according to a fourth embodiment will be described with reference to FIGS. 8 and 9.

FIG. 8 illustrates a configuration of a current sensor 103 according to the fourth embodiment. FIG. 9 is a circuit diagram illustrating an equivalent circuit of the current sensor 103 illustrated in FIG. 8.

As illustrated in FIG. 8, the current sensor 103 includes a pair of windings 111 and 112 and a difference circuit 30A instead of the pair of windings 11 and 21 and the difference circuit 30 constituting the current sensor 100 of the first embodiment. Since other configurations are the same as those of the current sensor 100 illustrated in FIG. 2, the same reference numerals are given and redundant descriptions will be omitted.

The pair of windings 111 and 112 are wound in the same direction as each other in the toroidal direction of the magnetic core 10. The other ends 1b and 2b of the pair of windings 111 and 112 are connected to the reference potential G.

One end 1a of the winding 111 is also one end of the return line 13, and one end 2a of the winding 112 is also one end of the return line 23. The other end 1b of the winding 111 is connected to the other end 2b of the winding 112. The other ends 1c and 2c of the pair of return lines 13 and 23 are connected to an inverting input terminal (-) and a non-inverting input terminal (+) of the difference circuit 30A, respectively.

As illustrated in FIG. 9, winding sections 111a to 111d obtained by dividing the winding 111 correspond to the winding sections 111a to 111d illustrated in FIG. 3. The resistance elements 12 are connected in parallel to the winding sections 111a to 111d while the resistance elements 12 are connected in series.

Winding sections 112a to 112d obtained by dividing the winding 112 correspond to the winding sections 112a to 112d illustrated in FIG. 3. The resistance elements 22 are connected in parallel to the winding sections 112a to 112d while the resistance elements 22 are connected in series.

The difference circuit 30A corresponds to the difference circuit 30 illustrated in FIG. 2. The difference circuit 30A generates and outputs an output signal Vout proportional to a magnitude of a difference between electrical signals output from the pair of windings 111 and 112 through the pair of return lines 13 and 23, respectively.

Next, functions and effects of the fourth embodiment will be described.

In the current sensor 103 of the fourth embodiment, the pair of windings 111 and 112 are wound in the same direction as each other in the toroidal direction of the magnetic core 10. The windings 111 and 112 are wound in the same poloidal direction. The other ends 1c and 2c of the pair of return lines 13 and 23 are connected to the inverting input terminal (-) as a first input terminal and the non-inverting input terminal (+) as a second input terminal of the difference circuit 30A, respectively. The other ends 1b and 2b of the pair of windings 111 and 112 are connected to the reference potential G.

That is, the current sensor 103 includes a pair of windings 111 and 112 for detecting a measurement current Im, and a plurality of resistance elements 12 and 22 connected in parallel to a plurality of sections of each winding. The pair of windings 111 and 112 are wound around different portions of the magnetic core 10 in the toroidal direction. The plurality of resistance elements 12 are connected in series, and similarly, the plurality of resistance elements 22 are also connected in series.

Further, the current sensor 103 further includes the difference circuit 30A that outputs the output signal Vout as a signal indicating the difference between the electrical signals output from the winding 111 and the return line 13 and the winding 112 and the return line 13. The pair of return lines 13 and 23 return from the one ends 1a and 2a toward the other ends 1b and 2b of the windings 111 and 112 along the toroidal direction of the portions of the magnetic core 10 around which the windings 111 and 112 are wound, respectively.

Unlike the first embodiment, in the current sensor 103, the pair of windings 111 and 112 are wound in the same poloidal direction, and the difference circuit 30A outputs a signal indicating a difference between a current passing through the return line 13 and a current passing through the return line 23.

With this configuration, the current sensor 103 cancels out at least a part of an in-phase component of noise caused by external magnetic fluxes or the like output through the winding 111 and the return line 13 by using noise caused by external magnetic fluxes or the like output through the winding 111 and the return line 23. Further, in the current sensor 103, the winding 111, which constitutes a part of a one-turn loop, cancels out at least a part of an anti-phase component of the external magnetic flux or the like caused by the winding 112, which constitutes another part (remaining part) of the one-turn loop, and the return line 13, which constitutes a part of a one-turn loop, cancels out at least a part of an anti-phase component of the external magnetic flux or the like caused by the return line 23, which constitutes another part of the one-turn loop.

For this reason, when detecting the measurement current Im, the current sensor 103 can reduce the noise caused by the external magnetic flux or the like, and as a result, the current detection accuracy can be improved.

In addition, since the pair of windings 111 and 112 are wound in the same direction, the pair of windings 111 and 112 can be configured more easily than the pair of windings 11 and 21 of the first embodiment. In addition, the wiring from the pair of return lines 13 and 23 to the difference circuit 30A is facilitated.

### (Fifth Embodiment)

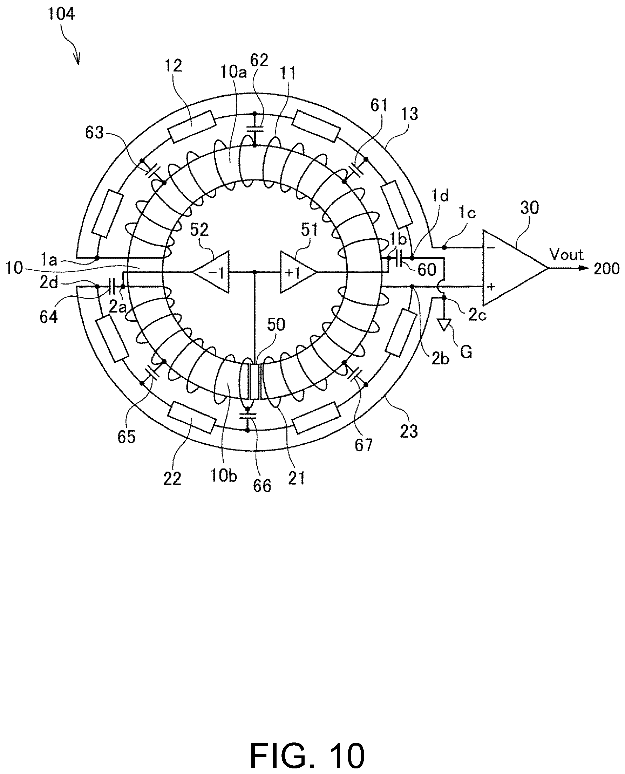

FIG. 10 illustrates a configuration of a current sensor 104 according to a fifth embodiment.

The current sensor 104 is a current sensor employing a zero-flux method, and can detect a current in a low frequency band lower than the high frequency band and including a direct current in addition to the current in the high frequency band.

The current sensor 104 includes, in addition to the configuration of the current sensor 100 of the first embodiment, a magnetic detection element 50, a pair of feedback circuits 51 and 52, and capacitive elements 60 to 67 between respective winding sections and resistance elements 12 and 22, which are connected in parallel. In FIG. 10, for convenience, an additional configuration is conceptually illustrated so that the connection relationship can be easily understood. Since other configurations are the same as those of the current sensor 100 illustrated in FIG. 2, the same reference numerals are given and redundant descriptions will be omitted.

The magnetic detection element 50 is attached to the magnetic core 10 and detects a magnetic flux generated in the magnetic core 10. The magnetic detection element 50 is implemented by, for example, a flux gate incorporated in the magnetic core 10, a Hall element inserted into a gap provided in the magnetic core 10, or a detection winding wound around the magnetic core 10.

The magnetic detection element 50 of the fifth embodiment is a flux gate formed in a gap of the magnetic core 10. The magnetic detection element 50 outputs a detection signal whose amplitude is proportional to a magnitude of the detected magnetic flux to the pair of feedback circuits 51 and 52.

The pair of feedback circuits 51 and 52 constitute a supply circuit that supplies to the pair of windings 11 and 21, based on the magnetic flux detected by the magnetic detection element 50, a signal for exciting the magnetic core 10 so as to offset the magnetic flux.

The feedback circuit 51 amplifies the output signal output from the magnetic detection element 50 and supplies the amplified output signal to the other end 1b of the winding 11. That is, the feedback circuit 51 supplies a signal for exciting the first magnetic core portion 10a of the magnetic core 10 to the other end 1b of the winding 11 so as to offset a measurement magnetic flux generated by the measurement current Im.

Accordingly, in the low frequency band, a magnetic flux in a direction opposite to the measurement magnetic flux generated by the measurement current Im is generated in the first magnetic core portion 10a of the magnetic core 10 around which the winding 11 is wound. For this reason, the current sensor 104 is in a zero-flux state in the first magnetic core portion 10a of the magnetic core 10 in the low frequency band.

The feedback circuit 52 inverts and amplifies a phase of the detection signal output from the magnetic detection element 50, and supplies the inverted and amplified output signal to the one end 2a of the winding 21. That is, the feedback circuit 52 supplies a signal for exciting the second magnetic core portion 10b of the magnetic core 10 to the one end 2a of the winding 21 so as to offset a measurement magnetic flux generated by the measurement current Im.

Accordingly, a magnetic flux in a direction opposite to the measurement magnetic flux generated by the measurement current Im is generated in the second magnetic core portion 10b of the magnetic core 10 around which the winding 21 is wound. For this reason, the current sensor 104 is in a zero-flux state in the second magnetic core portion 10b of the magnetic core 10 in the low frequency band.

The plurality of capacitive elements 60 to 67 are passive elements that block signal components from the direct current to the low frequency band.

The capacitive element 60 connects one end 1d of the plurality of resistance elements 12 connected in series and the other end 1b of the winding 11 constituted by the plurality of winding sections, and each of the capacitive elements 61 to 63 connects a connection point between adjacent resistance elements among the plurality of resistance elements 12 and a division point between winding sections corresponding to the resistance elements of the winding 11. The division point corresponds to a connection point to which one end of the capacitive element is connected.

The capacitive element 64 connects one end 2d of the plurality of resistance elements 22 connected in series and the one end 2a of the winding 21 constituted by the plurality of winding sections, and each of the capacitive elements 65 to 67 connects a connection point between adjacent resistance elements among the plurality of resistance elements 22 and a division point between winding sections corresponding to the resistance elements of the winding 21.

That is, the connection points between the adjacent resistance elements among the plurality of resistance elements 12 and the winding sections of the winding 11 are connected via the capacitive elements 61 to 63, and the connection points between the adjacent resistance elements among the plurality of resistance elements 12 and connection points between the adjacent winding sections of the winding 21 are connected via the capacitive elements 65 to 67. Further, output ends of the feedback circuits 51 and 52 constituting the supply circuit are connected to connection ends (1b and 2a) of the resistance elements, which are connection destinations of the outputs, via the capacitive elements 60 and 64, respectively.

In this way, the plurality of capacitive elements 60 to 67 are connected between the connection points between the adjacent resistance elements among the plurality of resistance elements 12 and the connection points between the adjacent winding sections of the windings 11 and 21, and between the output ends of the supply circuit and the connection ends (1b and 2a) of the resistance elements connected to the output ends.

The capacitive elements 60 to 67 can prevent a part of DC signals output from the feedback circuits 51 and 52 to the windings 11 and 12 from returning to the reference potential G through the resistance elements 12 and 22.

In this way, by adding the magnetic detection element 50 and the pair of feedback circuits 51 and 52, the current sensor 104 can detect the current in the low frequency band by the zero-flux method.

In the fifth embodiment, the example in which the magnetic detection element 50 is added to the configuration of the current sensor 100 illustrated in FIG. 2 in order to perform current detection by the zero-flux method has been described, but the present invention is not limited thereto, and the magnetic detection element 50 may be added to the configuration of the current sensor 103 illustrated in FIG. 8.

In this case, instead of the pair of feedback circuits 51 and 52, the supply circuit that supplies a signal for exciting a magnetic flux in a direction opposite to the measurement magnetic flux to the other ends 1b and 2b of the pair of windings 111 and 112 illustrated in FIG. 8 based on the detection signal of the magnetic detection element 50 is added.

Next, functions and effects of the fifth embodiment will be described.

The current sensor 104 of the fifth embodiment has the same configuration as the current sensor 101 of the first embodiment, and can achieve the same functions and effects as the first embodiment. That is, the current sensor 104 can increase the upper limit of the high frequency band in which the current can be detected.

In addition, the current sensor 104 includes the magnetic detection element 50 that detects a magnetic flux generated in the magnetic core 10. Further, the current sensor 104 includes the pair of feedback circuits 51 and 52 as a supply circuit that supplies to the pair of windings 11 and 21, based on the magnetic flux detected by the magnetic detection element 50, a signal for exciting the magnetic core 10 so as to offset the magnetic flux.

With this configuration, since the current can be detected by the zero-flux method, a lower limit of the low frequency band can be lowered to the direct current. For this reason, it is possible to increase the upper limit of the high frequency band while decreasing the lower limit of the low frequency band in which the current sensor 104 can detect the current.

### (Sixth Embodiment)

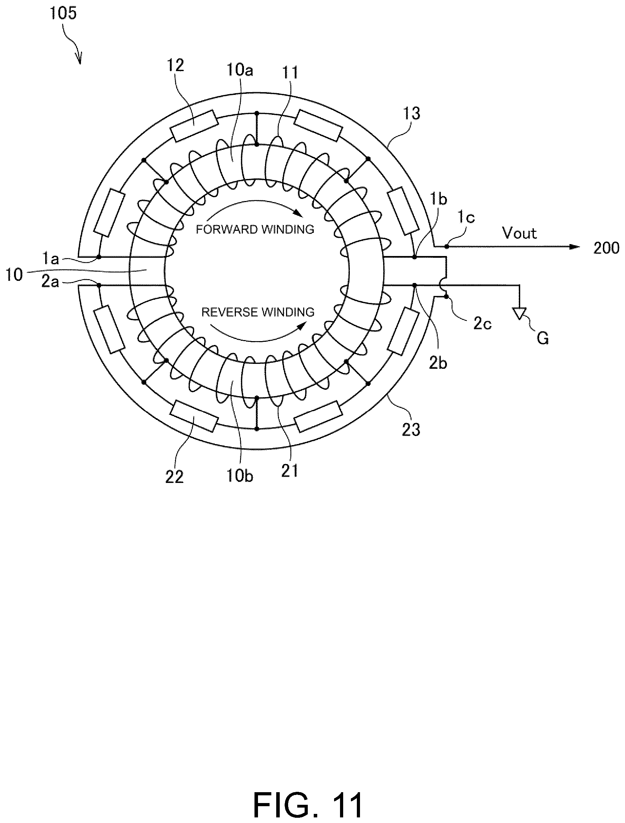

FIG. 11 illustrates a configuration of a current sensor 105 according to a sixth embodiment.

The current sensor 105 has a configuration in which the difference circuit 30 is removed from the configuration of the current sensor 100 of the first embodiment illustrated in FIG. 2. The same components as those of the current sensor 100 illustrated in FIG. 2 are denoted by the same reference numerals, and redundant descriptions thereof will be omitted.

In the sixth embodiment, the pair of windings 11 and 21 are wound such that a direction from the one end 1a to the other end 1b of the winding 11 and a direction from the one end 2a to the other end 2b of the winding 21 are opposite to each other in a toroidal direction of the magnetic core 10, and are wound in opposite directions in a poloidal direction of the magnetic core 10. The other end 2c of the return line 23 is connected to the other end 1b of the winding 11 without being connected to the reference potential G, and the other end 2b of the winding 21 is connected to the reference potential G.

For this reason, a signal output from the other end 1c of the return line 13 is a signal indicating a difference between magnetism generated in the winding 11 and the return line 13 and magnetism generated in the winding 21 and the return line 23, and is output to the measurement unit 200 as an output signal Vout of the current sensor 105.

Therefore, the current sensor 105 of the sixth embodiment has the same functions and effects as those of the first embodiment except for the functions and effects achieved by disposing the difference circuit 30 in the first embodiment. In particular, the current sensor 105 of the sixth embodiment employs a configuration in which the other end 2c of the return line 23 and the other end 1b of the winding 11 are connected, thereby outputting the output signal Vout indicating the difference between the magnetism generated in the winding 11 and the return line 13 and the magnetism generated in the winding 21 and the return line 23 as a difference between the output of the winding 11 and the return line 13 and the output of the winding 21 and the return line 23. With this configuration, the current sensor 105 can increase the upper limit of the high frequency band in which the current can be detected.

Although the embodiments of the present invention have been described above, the above embodiments merely exemplify some of application examples of the present invention and do not intend to limit the technical scope of the present invention to the specific configurations of the above embodiments.

In the above embodiments, a pair of wirings (11 and 13, and 21 and 23) including the pair of windings 11 and 21 and the pair of return lines 13 and 23 are both configured to be line-symmetric in the radial direction of the magnetic core 10, but may be configured to offset parasitic magnetic fluxes of the pair of wirings. That is, a pair of windings and a pair of return lines may be configured to be substantially line-symmetric.

In the above embodiments, the example in which the entire portion of the magnetic core 10 in the toroidal direction is wound by the winding 11 and the winding 21 has been described, but the present invention is not limited thereto, and a portion of the magnetic core 10 in the toroidal direction may be wound by the winding 11 and the winding 21. In addition to the winding 11 and the winding 21, another one or a plurality of pairs of windings having the same function may be wound in the toroidal direction of the magnetic core 10.

For example, in the above embodiments, the example in which two semicircular windings are wound around the magnetic core 10 to face each other has been described, but the present invention is not limited thereto, and a pair of windings may be wound to bisect a semicircular portion of the magnetic core 10.

In the above embodiments, the configuration has been adopted in which the pair of return lines 13 and 23 extend in opposite directions along the toroidal direction of the magnetic core 10, but instead, a configuration may be adopted in which the pair of return lines 13 and 23 extend in the same direction along the toroidal direction of the magnetic core 10. With such a configuration, the same functions and effects as those of the above embodiments can be achieved.

The present application claims priority based on Japanese Patent Application No. 2022-202496 filed to the Japan Patent Office on December 19, 2022 and priority based on Japanese Patent Application No. 2023-181979 filed to the Japan Patent Office on October 23, 2023, and all contents of these applications are incorporated herein by reference.

### DESCRIPTION OF REFERENCE SIGNS

1 measurement device
1a, 2a one end of winding, one end of return line
1b, 2b the other end of winding
1c, 2c the other end of return line
10 magnetic core
10a, 10b first magnetic core portion, second magnetic core portion (different portions)
11, 21, 111, 112 winding (first winding, second winding, a pair of windings)
12, 22 resistance element
13, 23 return line
14, 24 transmission line
15, 25 resistance element
30, 30A difference circuit
40 impedance adjustment circuit
50 magnetic detection element
51, 52 feedback circuit (supply circuit)
60~67 capacitive element
100~104 current sensor
200 measurement unit
Lm measurement target
Im measurement current

## Claims

1. A current sensor comprising:
an annular magnetic core;
a pair of windings including a first winding and a second winding, the first winding and the second winding each including a plurality of winding sections connected in series and wound around different portions of the magnetic core in a poloidal direction along a toroidal direction to detect a current flowing through a measurement target;
a plurality of resistance elements, each resistance element connected in parallel to a respective winding section of the plurality of winding sections;
a first return line with one end connected to one end of the first winding and the other end extending from the one end of the first winding to a position near the other end of the first winding along a toroidal direction of a portion of the magnetic core around which the first winding is wound; and
a second return line with one end connected to one end of the second winding and the other end extending from the one end of the second winding to a position near the other end of the second winding along a toroidal direction of a portion of the magnetic core around which the second winding is wound, wherein
the current sensor is configured to a signal indicating a difference between an output of the first winding and the first return line and an output of the second winding and the second return line.

2. The current sensor according to claim 1, wherein
the difference includes a difference in magnetism.

3. The current sensor according to claim 1, further comprising:
a difference circuit configured to output a signal indicating the difference, wherein
the difference includes a difference in electrical signals.

4. The current sensor according to claim 1, further comprising:
a difference circuit configured to output a signal indicating the difference, wherein
the difference includes a difference in magnetism and a difference in electrical signals.

5. The current sensor according to any one of claims 1 to 4,
wherein
the number of turns of the first winding and the number of turns of the second winding are equal to each other.

6. The current sensor according to any one of claims 1 to 5,
wherein
the different portions of the magnetic core include a first magnetic core portion and a second magnetic core portion, and
a circumferential length of the first magnetic core portion and a circumferential length of the second magnetic core portion are equal to each other.

7. The current sensor according to any one of claims 1 to 6,
wherein
the other end of the first winding and the other end of the second winding are adjacent to each other.

8. The current sensor according to any one of claims 1 to 7,
wherein
the pair of windings are wound such that a direction from the one end of the first winding to the other end of the first winding and a direction from the one end of the second winding to the other end of the second winding are opposite to each other in a toroidal direction of the magnetic core, and are wound in opposite directions in a poloidal direction of the magnetic core, and
the other end of the second return line is connected to the other end of the first winding.

9. The current sensor according to any one of claims 1 to 7, further comprising:
a difference circuit configured to output a signal indicating the difference,
wherein
the pair of windings are wound such that a direction from the one end of the first winding to the other end of the first winding and a direction from the one end of the second winding to the other end of the second winding are opposite to each other in a toroidal direction of the magnetic core, and are wound in opposite directions in a poloidal direction of the magnetic core,
the other end of the first return line is connected to a first input terminal of the difference circuit, and the other end of the second winding is connected to a second input terminal of the difference circuit, and
the other end of the second return line and the other end of the first winding are each connected to a reference potential.

10. The current sensor according to any one of claims 1 to 7, further comprising:
a difference circuit configured to output a signal indicating the difference, wherein
the pair of windings are wound such that a direction from the one end of the first winding to the other end of the first winding and a direction from the one end of the second winding to the other end of the second winding are opposite to each other in a toroidal direction of the magnetic core, and are wound in the same direction as each other in a poloidal direction of the magnetic core,
the other end of the first return line and the other end of the second return line are connected to a first input terminal and a second input terminal of the difference circuit, respectively, and
the other end of the first winding and the other end of the second winding are each connected to a reference potential.

11. The current sensor according to any one of claims 1 to 10,
wherein
resistance values of the plurality of resistance elements are equal to each other.

12. The current sensor according to any one of claims 1 to 11, further comprising:
a difference circuit configured to output a signal indicating the difference;
and
a pair of transmission lines configured to transmit an output of the first winding and the first return line and an output of the second winding and the second return line to the difference circuit, separately, wherein
a sum of resistance values of the plurality of resistance elements connected in parallel to at least one of the first winding and the second winding is substantially equal to a characteristic impedance of the transmission line.

13. The current sensor according to any one of claims 1 to 12, further comprising:
a difference circuit configured to output a signal indicating the difference;
a pair of transmission lines configured to transmit an output of the first winding and the first return line and an output of the second winding and the second return line to the difference circuit, separately; and
an impedance adjustment circuit configured to adjust an impedance viewed from an input end of at least one of the pair of transmission lines to a characteristic impedance of the transmission line.

14. The current sensor according to any one of claims 1 to 13, further comprising:
a magnetic detection element configured to detect a magnetic flux generated in the magnetic core;
a supply circuit configured to supply to the pair of windings, based on the magnetic flux detected by the magnetic detection element, a signal for exciting the magnetic core to offset the magnetic flux; and
a plurality of capacitive elements configured to block signal components from a direct current to a low frequency band, wherein
the plurality of capacitive elements are connected between connection points between adjacent resistance elements among the plurality of resistance elements and connection points between adjacent winding sections, and between output ends of the supply circuit and the resistance elements connected to the output ends.

15. A measurement device comprising: the current sensor according to any one of claims 1 to 14; and
a measurement unit configured to calculate a measurement quantity of the measurement target based on a detection quantity detected by the current sensor.
